# EUROPÄISCHE PATENTANMELDUNG

(11) **EP 1 489 196 A1**
(43) Veröffentlichungstag der Anmeldung: **22.12.2004**
(21) Anmeldenummer: 04012370.5
(22) Anmeldetag: 25.05.2004
(51) Int. Cl.: C23C 14/08, H01L 31/18

(54) **"Verfahren zur Herstellung Indium-Zinn-Oxidschichten.**

(30) Priorität: 20.06.2003 DE 10327897
(71) Anmelder: Applied Films GmbH & Co. KG, 63755 Alzenau (DE)
(72) Erfinder: Bender, Marcus, Dr., 63456 Hanau (DE)
(74) Vertreter: GROSSE BOCKHORNI SCHUMACHER

(57) **Zusammenfassung**

Bei einem Verfahren zur Herstellung von ITO-Schichten auf Substraten, insbesondere für die Produktion von organischen Leuchtdioden, wird zuerst eine ITO-Schicht mit einer Teildicke durch Sputtern bei einem gesteuerten Temperaturprofil derart aufgebracht, dass die Ausbildung von Kristallisationskeimen unterbleibt, wonach das teilbeschichtete Substrat auf eine Temperatur oberhalb der Rekristallistionstemperatur der ITO-Schicht aufgeheizt und schließlich die restliche ITO-Schicht aufgesputtert wird.

## Beschreibung

Die Erfindung bezieht sich auf ein Verfahren zur Herstellung glatter Metalloxidschichten, insbesondere Indium-Zinn-Oxidschichten auf Substraten, die insbesondere für die Produktion von organischen Leuchtdioden verwendet werden. Die Erfindung betrifft ferner eine Substratbeschichtung aus Indium-Zinn-Oxid.

Organische Leuchtdioden (sog. OLEDs) werden im allgemeinen dadurch hergestellt, dass eine transparente leitfähige Schicht auf einem Glassubstrat aufgebracht wird, welche nach dem Aufbringen strukturiert wird und dann als Elektrode wirkt. Auf diese transparente Elektrode werden dann verschiedene Schichten aus organischen Materialen abgelagert, wobei diese organischen Schichten sehr dünn sind und im allgemeinen im Bereich von wenigen 10 nm liegen. Um Kurzschlüsse oder andere Defekte zu vermeiden, die durch Spitzen oder Kanten auf der Oberfläche verursacht werden können, muss deswegen die transparente Elektrode eine sehr glatte Oberfläche aufweisen. Komplettiert wird schließlich das Display durch eine im allgemeinen metallische Gegenelektrode, wonach dann eine Verkapselung erfolgt.
In Zusammenhang mit dem Abscheiden glatter Indium-Zinn-Oxidschichten (im folgenden mit ITO-Schichten bezeichnet) wird häufig ein ionenunterstützes Sputtern, sog. Ion-Plating, verwendet, mit dem man bei niedrigen Temperaturen glatte Schichten erreichen kann. Unter diesen Verfahren ist z. B. das Skion-Verfahren bekannt. Allerdings erfordert das ionenunterstütze Sputtern zusätzlich zur als Kathode wirkenden Sputterquelle eine Ionenquelle, was die Anlagenkosten nicht unbeträchtlich erhöht, was sich zwangsläufig auf die Produktionskosten für die Herstellung derartiger OLED-Displays niederschlägt. Bei Verwendung üblicher Standardsputterverfahren ist es allerdings erforderlich, dass zusätzlich ein mechanischer Polierschritt und damit ein zusätzlicher Prozessschritt erfolgt, der gleichfalls die Produktionskosten für derartige OLED-Displays erhöht.

Bei der Verwendung üblicher Standardsputterquellen, insbesondere dem DC-Magnetronverfahren, werden die Schichten auf Substrate aufgebracht, die zur Erzielung guter elektrischer und optischer Eigenschaften auf Temperaturen oberhalb der Rekristallisationstemperatur des Materials (ca. 150°C für ITO) abgeschieden werden. Hierbei wird üblicherweise das Substrat auf Temperaturen von ca. 200°C aufgeheizt. Dieser Aufheizprozess erfolgt deswegen, da bei niedrigeren Temperaturen die spezifischen Widerstände und Transmissionsgrade von Indium-Zinn-Oxidschichten nicht den elektrischen und optischen Anforderungen genügen. Bei solchen Verfahren wächst der Film mikrokristallin auf und es können sich Spitzen auf der Filmoberfläche bilden. Versuche haben gezeigt, dass die durch das DC-Magnetronverfahren aufgesputterten ITO-Schichten bei einer Substrattemperatur von 200°C eine rms-Rauhigkeit von 2,3 nm und eine maximale Rauhigkeit von 16,1 nm aufweisen. Bringt man auf eine solche Schicht, die für die Herstellung von organischen Leuchtdioden erforderlichen dünnen Schichten aus organischen Materialen auf, dann ist ein mechanischer Polierschritt erforderlich, um Kurzschlüsse oder andere Defekte, bedingt durch Spitzen oder Kanten auf der Oberfläche, zu vermeiden. Dadurch kompliziert sich al lerdings die Herstellung derartiger organischer Leuchtdioden und erhöhen sich zudem die Produktionskosten.

Aufgabe der Erfindung ist es, glatte Metalloxidschichten, insbesondere glatte ITO-Schichten auf Substraten in einfacher und kostengünstiger Weise herzustellen, insbesondere unter Verwendung von Standardsputterquellen, wie DC-Magnetron bzw. HF/DC-pulsed-Magnetronverfahren (Gleichstrom-Sputtern bzw. hochfrequentes pulsiertes Gleichstrom-Sputtem). Diese Aufgabe wird erfindungsgemäß für ein Verfahren durch die kennzeichnenden Merkmale des Anspruchs 1 gelöst sowie für eine Substratbeschichtung mit den Merkmalen des Anspruches 6.

Die Erfindung geht von der Überlegung aus, dass bei kalt abgeschiedenen Schichten, insbesondere Indium-Zinn-Oxidschichten, erst ab einer Schichtdicke von mehr als 70 nm Kristallisationskeime auftreten, die auch bei einem Nachtempern des Substrats verbleiben, weshalb nach Maßgabe der Erfindung in einem ersten Schritt die Metalloxidschicht nur mit einer Teildicke der Gesamtschicht bei einem derart gesteuerten Temperaturprofil aufgesputtert wird, dass die Ausbildung von Kristallisationskeimen unterbleibt. Danach erfolgt dann das Aufheizen des Substrats auf eine Temperatur oberhalb der Rekristallisationstemperatur, die bei einer ITO-Schicht bei ca. 150°C liegt. Danach wird dann die Restdicke der ITO-Schicht aufgesputtert.

Vorteilhafterweise werden die ITO-Schichten im ersten Beschichtungsschritt mit einer Teildicke kleiner 70 nm aufgebracht, wobei ein besonders bevorzugter Bereich bei 25 nm bis 50 nm liegt. Zweckmäßigerweise erfolgt die Beschichtung hierbei auf einem kalten Substrat, jedenfalls auf einem Substrat, welches unter 150°C, also der Rekristallisationstemperatur der Indium-Zinn-Oxidschicht liegt. Zweckmäßigerweise erfolgt die Beschichtung bei einer Substrattemperatur von 100°C oder niedriger, insbesondere im Bereich von 15°C bis 30°C, also insbesondere bevorzugt bei Raumtemperatur.

Zweckmäßigerweise erfolgt danach das Aufheizen, des mit einer Teildicke beschichteten Substrats auf eine Temperatur von ca. 180°C und darüber, woraufhin dann die restliche ITO-Schicht aufgesputtert wird.

Nach Maßgabe der Erfindung lassen sich somit glatte ITO-Schichten mit bekannter Anlagentechnologie, also üblichen Standardsputterverfahren, wie DC-Magnetronverfahren bzw. HF/DC-pulsed-Magnetronverfahren aufbringen, ohne das ein nachgelagerter zusätzlicher Prozessschritt zur Glättung der Indium-Zinn-Oxidschicht erforderlich ist. Insbesondere kann auch eine aufwendige, teure und schwer zu beherrschende ionenunterstütze Sputtertechnologie vermieden werden. Erreicht wird dies unter Ausnutzung der temperaturabhängigen Wachstumskinetik der Indium-Zinn-Oxidschichten.

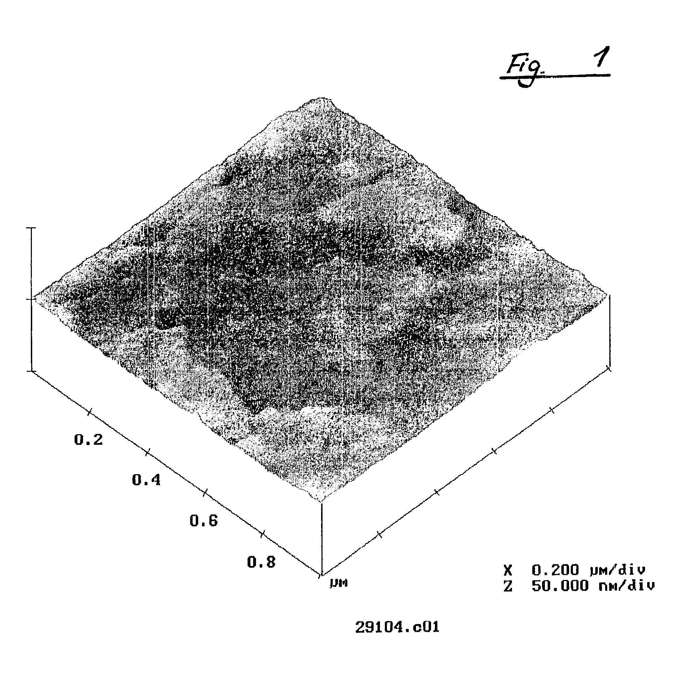

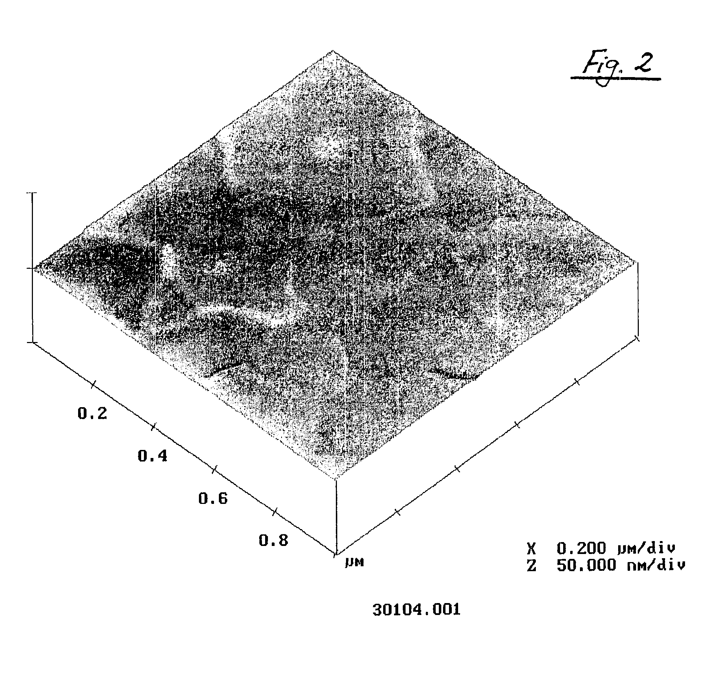

Nachfolgend wird die Erfindung anhand zweier Ausführungsbeispiele erläutert und zwar anhand der Abbildungen 1 und 2, welche nach dem erfindungsgemäßen Verfahren hergestellte ITO-Filme zeigen.

### Beispiel 1

Ein Glassubstrat wird bei Raumtemperatur mit dem DC-Magnetron-Sputterfahren mit 35 nm ITO bei einer Leistungsdichte von 2 W/cm² beschichtet. Nach dieser Beschichtung wird das Substrat auf 200°C aufgeheizt und unter Beibehaltung dieser Substrattemperatur werden weitere 105 nm ITO bei einer Leistungsdichte von 2 W/cm² beschichtet. Der auf dem Substrat abgeschiedene Film hat eine Gesamtdicke von 140 nm, einen spezifischen Wiederstand von 200 µΩ cm, eine Transmission bei einer Wellenlänge von 550 nm von 85 %, eine rms-Rauhigkeit von 1,0 nm und eine maximale Rauhigkeit von 10,8 (Fig. 1)

### Beispiel 2

Ein Glassubstrat wird bei Raumtemperatur mit dem HF/DC-pulsed-Magnetron-Sputterverfahren mit 49 nm ITO bei einer Leistungsdichte von 2,25 W/cm² beschichtet. Nach dieser Beschichtung wird das Substrat auf 200°C aufgeheizt und unter Beibehaltung dieser Substrattemperatur werden weitere 91 nm ITO bei einer Leistungsdichte von 2,25 W/cm² beschichtet. Der auf dem Substrat abgeschiedene Film hat eine Gesamtdicke von 140 nm, einen spezifischen Widerstand von 200 µΩ cm, eine Transmission bei einer Wellenlänge von 550 nm von 88 %, eine rms-Rauhigkeit von 0,42 nm und eine maximale Rauhigkeit von 4,7 nm (Fig. 2)

Mit dem erfindungsgemäßen Verfahren lassen sich somit niederohmige transparente und leitfähige Indium-Zinn-Oxidschichten mit sehr geringer Oberflächenrauhigkeit herstellen, so dass ein mechanisches Nachpolieren nicht erforderlich ist. Vielmehr können die, für die Herstellung von organischen Leuchtdioden, erforderlichen dünnen Schichten aus organischen Materialien ohne weiteres aufgebracht werden.

## Patentansprüche

1. Verfahren zur Herstellung glatter Metalloxidschichten, insbesondere Indium-Zinn-Oxidschichten (ITO-Schichten) auf Substraten, insbesondere für die Produktion von organischen Leuchtdioden, für deren Herstellung auf einem Glassubstrat eine transparente leitfähige ITO-Schicht zur Bildung einer Elektrode aufgebracht wird, **dadurch gekennzeichnet, dass** zur Bildung der ITO-Schicht diese zuerst mit einer Teildicke bei einem derart gesteuerten Temperaturprofil aufgesputtert wird, dass die Ausbildung von Kristallisationskeimen unterbleibt, danach das Substrat auf eine Temperatur oberhalb der Rekristallisationstemperatur der ITO-Schicht aufgeheizt und schließlich die restliche ITO-Schicht aufgesputtert wird.

2. Verfahren nach Anspruch 1, **dadurch gekennzeichnet, dass** die Teildicke der zuerst aufgesputterten ITO-Schicht kleiner als 70 nm ist, vorzugsweise im Bereich von 25 nm bis 50 nm liegt.

3. Verfahren nach Anspruch 1 oder 2, **dadurch gekennzeichnet, dass** das Sputtern durch DC oder HF/DC gepulstes Magnetron-Sputtern erfolgt.

4. Verfahren nach einem der Ansprüche 1 bis 3, **dadurch gekennzeichnet, dass** die erste Teilschicht auf ein kaltes Substrat aufgesputtert wird, insbesondere auf ein Substrat mit einer Temperatur kleiner 150°C, vorzugsweise auf ein Substrat mit einer Temperatur von etwa 100°C und niedriger

5. Verfahren nach einem der Ansprüche 1 bis 4, **dadurch gekennzeichnet, dass** das Aufheizen des teilbeschichteten Substrats auf eine Temperatur größer oder gleich 150°C erfolgt, vorzugsweise 180°C und darüber.

6. Substratbeschichtung aus Indium-Zinn-Oxid, insbesondere für die Herstellung von organischen Leuchtdioden, **dadurch gekennzeichnet, dass** die Substratbeschichtung eine erste kristallisationsfreie ITO-Schicht mit einer Dicke kleiner 70 nm aufweist und darauf eine ITO-Schicht mit Restdicke aufgebracht ist, insbesondere nach einem Verfahren gemäß den Ansprüchen 1 bis 5.

7. Organische Leuchtdiode mit glatter Indium-Zinn-Oxidschicht, hergestellt nach einem Verfahren der Ansprüche 1 bis 5.
